Europäisches Patentamt

European Patent Office

Office européen des brevets

(11) Publication number: **0 664 561 A2**

# EUROPEAN PATENT APPLICATION

(21) Application number: **94119062.1**

(22) Date of filing: **02.12.94**

(51) Int. Cl.6: **H01L 21/3205**, H01L 21/336

(30) Priority: **30.12.93 JP 352438/93**

(43) Date of publication of application:
**26.07.95 Bulletin 95/30**

(84) Designated Contracting States:
**DE FR GB**

(71) Applicant: **NEC CORPORATION**
**7-1, Shiba 5-chome**
**Minato-ku**
**Tokyo (JP)**

(72) Inventor: **Sakai, Isami, c/o NEC Corporation**
**7-1, Shiba 5-chome**
**Minato-ku,**
**Tokyo (JP)**

(74) Representative: **Glawe, Delfs, Moll & Partner**
**Patentanwälte**
**Postfach 26 01 62**
**D-80058 München (DE)**

(54) Method for manufacturing polycrystalline layer having uniform metal silicide layer thereon.

(57) In a method for manufacturing a semiconductor device, a polycrystalline layer (4) is formed on a semiconductor substrate (1), and a sidewall insulating layer (6') having a smaller height than this polycrystalline silicon layer is formed on a side surface of the polycrystalline silicon layer. Next, a high melting point (refractory) metal layer (8) is formed on the entire surface, and a heat process is carried out so that this high melting point metal layer reacts on the polycrystalline silicon layer to form a metal silicide layer (9').

Fig. 2C

Fig. 2D

## BACKGROUND OF THE INVENTION

### Field of the Invention

The present invention relates to a method for manufacturing a semiconductor device, and more particularly, to a method for manufacturing a polycrystalline silicon layer having a metal silicide layer thereon.

### Description of the Related Art

In a metal oxide semiconductor (MOS) device, in order to reduce a gate sheet resistance, a double layer made of polycrystalline silicon and metal silicide such as TiSi has been used. In a prior art method for manufacturing such a MOS device, a polycrystalline layer is formed on a semiconductor substrate, and a sidewall insulating layer having the same height as this polycrystalline silicon layer is formed on a side surface of the polycrystalline silicon layer. Next, a high melting point metal layer made of titanium or the like is formed on the entire surface, and a heat process is carried out so that this high melting point metal layer reacts on the polycrystalline silicon layer to form a metal silicide layer (see Thomas E. TANG et al, "Titanium Nitride Local Interconnect Technology for VLSI", IEEE Trans. of Electron Devices, Vol. ED-34, No. 3, March 1987).

In the above-mentioned prior art method, however, the thickness of the metal silicide layer is not uniform, so that the sheet resistance of the metal silicide layer fluctuates and increases, thereby increasing the manufacturing cost. This will be explained later in detail.

## SUMMARY OF THE INVENTION

It is an object of the present invention to provide a method for manufacturing a semiconductor device which can avoid the fluctuation and increase of a sheet resistance of a metal silicide layer, thus reducing the manufacturing cost of the semiconductor device.

According to the present invention, a polycrystalline layer is formed on a semiconductor substrate, and a sidewall insulating layer having a smaller height than this polycrystalline silicon layer is formed on a side surface of the polycrystalline silicon layer. Next, a high melting point (refractory) metal layer is formed on the entire surface, and a heat process is carried out so that this refractory metal layer reacts on the polycrystalline silicon layer to form a metal silicide layer. Thus, the thickness of the metal silicide layer on the polycrystalline silicon layer becomes homogeneous.

## BRIEF DESCRIPTION OF THE DRAWINGS

The present invention will be more clearly understood from the description as set forth below, with reference to the accompanying drawings, wherein:

Figs. 1A through 1D are cross-sectional views illustrating a prior art method for manufacturing a semiconductor device;

Figs. 2A through 2D are cross-sectional views illustrating a first embodiment of the method for manufacturing a semiconductor device according to the present invention;

Figs. 3A through 3F are cross-sectional views illustrating a second embodiment of the method for manufacturing a semiconductor device according to the present invention; and

Fig. 4 is a graph showing a sheet resistance of titanium silicide according to the present invention.

## DESCRIPTION OF THE PREFERRED EMBODIMENTS

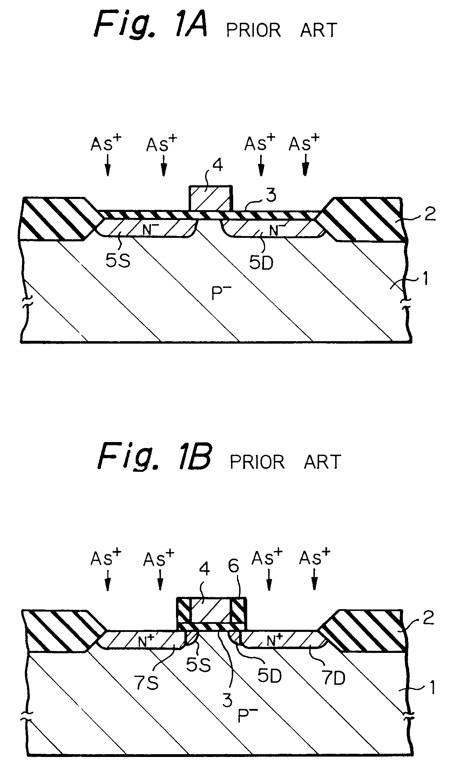

Before the description of the preferred embodiments, a prior art method for manufacturing a MOS transistor having a gate, a source and a drain made of metal silicide will be explained with reference to Figs. 1A through 1D (see Thomas E. TANG et al,"Titanium Nitride Local Interconnect Technology for VLSI", IEEE Trans. of Electron Devices, Vol. ED-34, No. 3, March 1987).

As illustrated in Fig. 1A, a relatively thick field oxide layer 2 is formed by thermal oxidation in a field (inactive) area of a $P^-$-type monocrystalline silicon substrate 1, and thereafter, an about 10 nm thick gate oxide layer 3 is formed in an active area. Next, an about 200 nm thick polycrystalline silicon layer (gate) 4 made of phosphorus-doped polycrystalline silicon is formed on the gate oxide layer 3. Next, N-type impurities such as arsenic (As) are doped with a mask of the field oxide layer 2 and the polycrystalline silicon layer 4 to form $N^-$-type impurity diffusion regions (source and drain regions) 5S and 5D.

Next, as illustrated in Fig. 1B, an about 200 nm thick silicon oxide layer is grown by a low temprature chemical vapor deposition CVD at an about 400°C, and thereafter, this layer is etched back by an anisotropic etching to leave a sidewall oxide layer 6. N-type impurities such as arsenic (As) are doped with a mask of the field oxide layer 2, the polycrystalline silicon layer 4 and the sidewall oxide layer 6 to form $N^+$-type impurity diffusion regions (source and drain region) 7S and 7D.

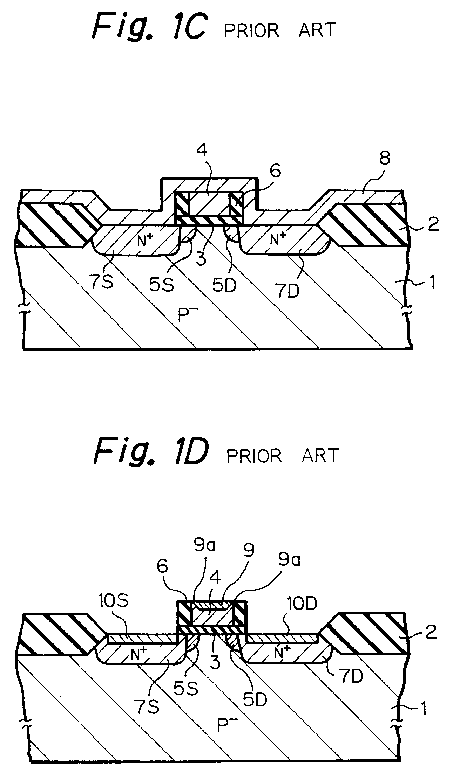

Next, as illustrated in Fig. 1C, a native oxide layer and an exposed portion of the gate oxide layer 3 on the polycrystalline silicon layer 4 are etched out by buffered fluoric acid. In this case, note that the thickness of the gate oxide layer 3 is about 10 nm. Also, the height of the sidewall oxide layer 6 is about 200 nm, and therefore, the height of the sidewall oxide layer 6 is hardly changed when the gate oxide layer 3 is etched out. Next, an about 100 nm thick titanium layer 8 is formed by a sputtering method.

Next, as illustrated in Fig. 1D, the titanium layer 8 is reacted by a heat treatment under a nitrogen atmosphere on the polycrystalline silicon layer 4 and the $N^+$-type impurity diffusion regions 7S and 7D, to thereby form a titanium silicide layer 9 on the polycrystalline silicon layer 4 and titanium silicide layers 10S and 10D on the diffusion regions 7S and 7D, respectively. After that, an unreacted potion of the titanium layer 8 on the field oxide layer 2 and the sidewall oxide layer 6 are removed by a wet etching method.

After that, an insulating interlayer (not shown) is deposited, and contact holes (not shown) are formed in this insulating interlayer. Further, aluminum connection layers (not shown) are formed within the contact holes, thus completing a MOS transistor with a lightly doped drain (LDD) construction.

According to the above-mentioned prior art manufacturing method as illustrated in Figs. 1A through 1D, however, as explained above, side portions 9a of the titanium silicide layer 9 formed in self-alignment with the polycrystalline silicon layer 4, i.e., the portions 9a in contact with the sidewall oxide layer 6, are thinner than a central portion of the titanium silicide layer 9. This is because a reaction speed of polycrystalline silicon on titanium is reduced at the portions in contact with the sidewall oxide layers 6 for some reason.

Thus, when the titanium silicide layer 9 having thin portion on both sides of the gate electrode is fine-structured, the thick center portion of the titanium silicide layer 9 becomes thinner, to thereby increase the resistance of the titanium silicide layer 9. Also, since the both sides of the titanium silicide layer 9 are not homogenously formed, the fluctuation of the sheet resistance of the titanium silicide layer 9 is increased. Further, the thin side portions 9a of the titanium silicide layer 9 are agglomerated by a heat treatment such as a reflowing process of the interlayer after the formation of the titanium silicide layer 9, increasing the sheet resistance of the titanium silicide layer 9. As a result, a desired performance of the semiconductor device cannot be obtained, thus reducing the manufacturing yield, thus increasing the manufacturing cost. Note that, in order to obtain a desired sheet resistance of the gate electrode, when the titanium silicide layer 9 is made thicker, the titanium sislicide layer 9 may be in contact with the gate oxide layer 3 at the center of the polycrystalline silicon layer 4, which deteriorates the film property of the gate oxide layer 3.

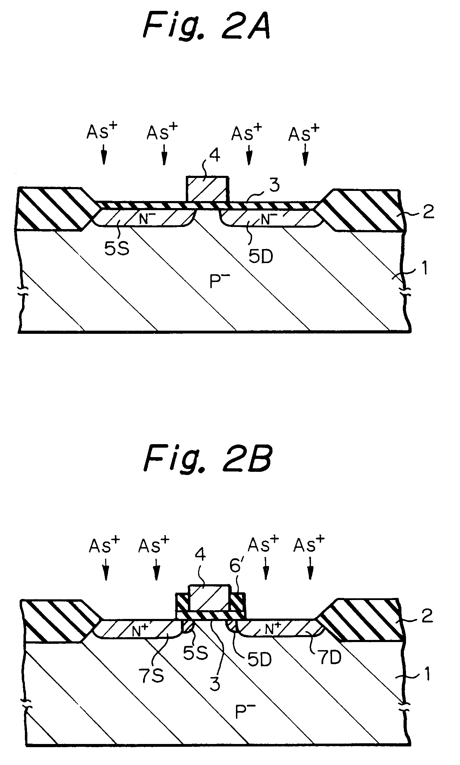

Figs. 2A through 2D show a first embodiment of the method for manufacturing a semiconductor device. Figs. 2A through 2D correspond to Figs. 1A thtough 1D, respectively.

First, in Fig. 2A, in the same way as in Fig. 1A, a relatively thick field oxide layer 2 is formed by thermal oxidation in a field (inactive) area of a $P^-$-type monocrystalline silicon substrate 1, and thereafter, an about 10 nm thick gate oxide layer 3 is formed in an acitve area. Next, an about 200 nm thick polycrystalline silicon layer (gate) 4 made of phosphorus-doped polycrystalline silicon is formed on the gate oxide layer 3, Next, N-type impurities such as arsenic (As) are doped with a mask of the field oxide layer 2 and the polycrystalline silicon layer 4 to form $N^-$-type impurity diffusion regions (source and drain regions) 5S and 5D.

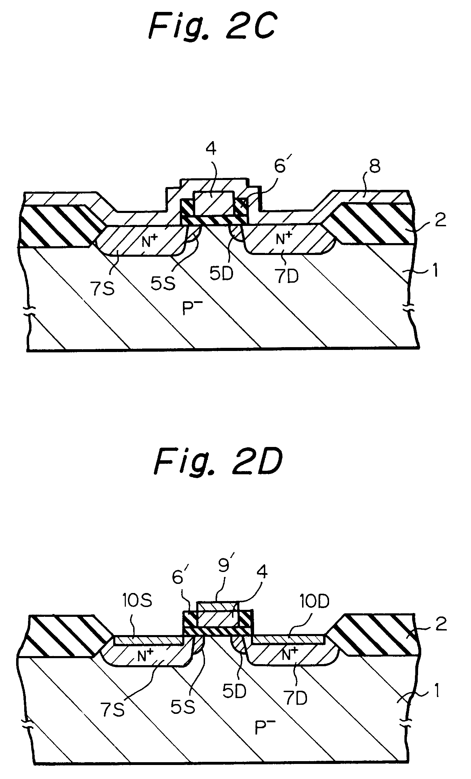

Next, in Fig. 2B, in the same way as in Fig. 1B, an about 200 nm thick silicon oxide layer is grown by a low temperature CVD at about 400°C. Thereafter, this layer is etched by an anisotropic etching; however, in this case, this etching is carried out for only a time period corresponding to a thickness of 250 nm of the silicon oxide layer. As a result, a sidewall oxide layer 6' lower than the polycrystalline silicon layer 4 by about 50 nm remains. At this time, the gate oxide layer 3 on the impurity diffusion layer 5 is also removed. Next, N-type impurities such as arsenic (As) are doped with a mask of the field oxide layer 2, the polycrystalline silicon layer 4 and the sidewall oxide layer 6 to form $N^+$-type impurity diffusion regions (source and drain regions) 7S and 7D. Next, as illustrated in Fig. 2C, a native oxide layer on the polycrystalline silicon layer 4 and the impurity diffusion regions 7S and 7D is etched out by buffered fluoric acid. Next, an about 100 nm thick titanium layer 8 is formed by a sputtering method.

Next, in Fig. 2D, in the same way as in Fig. 1D, the titanium layer 8 is reacted by a heat treatment under a nitrogen atmosphere on the polycrystalline silicon layer 4 and the $N^+$-type impurity diffusion layers 7, to thereby form a titanium silicide layer 9' on the polycrystalline silicon layer 4 and titanium silicide layers 10S and 10D on the diffusion regions 7S and 7D, respectively. After that, an unreacted potion of the titanium layer 8 on the field oxide layer 2 and the sidewall oxide layer 6 are removed by a wet etching method.

After that, in the same way as in the prior art, an insulating interlayer (not shown) is deposited, and contact holes (not shown) are formed in this insulating interlayer. Further, aluminum connection layers (not shown) are formed within the contact holes, thus completing a MOS transistor with an LDD construction.

Thus, according to the first embodiment, since the sidewall oxide layer 6' is lower than the polycrystalline silicon layer 4, the thickness of the titanium silicide layer 9' on the polycrystalline silicon layer 4 can be uniform at the center and side portions thereof.

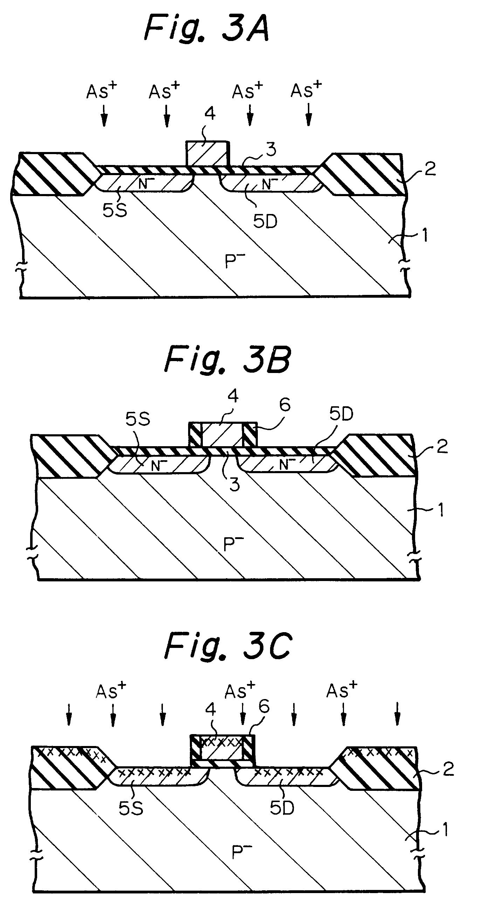

Figs. 3A through 3F show a second embodiment of the method for manufacturing a semiconductor device.

First, in Fig. 3A, in the same way as in Fig. 1A, a relatively thick field oxide layer 2 is formed by thermal oxidation in a field (inactive) area of a P⁻-type monocrystalline silicon substrate 1, and thereafter, an about 10 nm thick gate oxide layer 3 is formed in an active area. Next, an about 200 nm thick polycrystalline silicon layer (gate) 4 made of phosphorus-doped polycrystalline silicon is formed on the gate oxide layer 3. Next, N-type inpurities such as arsenic (As) are doped with a mask of the field oxide layer 2 and the polycrystalline silicon layer 4 to form N⁻-type impurity diffusion regions (source and drain regions) 5S and 5D.

Next, in Fig. 3B, in the same way as in Fig. 1B, an about 200 nm thick silicon oxide layer is grown by a low temprature CVD at about 400°C. Thereafter, this layer is etched by an anisotropic etching, and a sidewall oxide layer 6 remains.

Next, as illustrated in Fig. 3C, impurities such as arsenic (As) are ion-doped at an energy of 30 keV and a dose of $5 \times 10^{14}/_{cm}^{2}$.

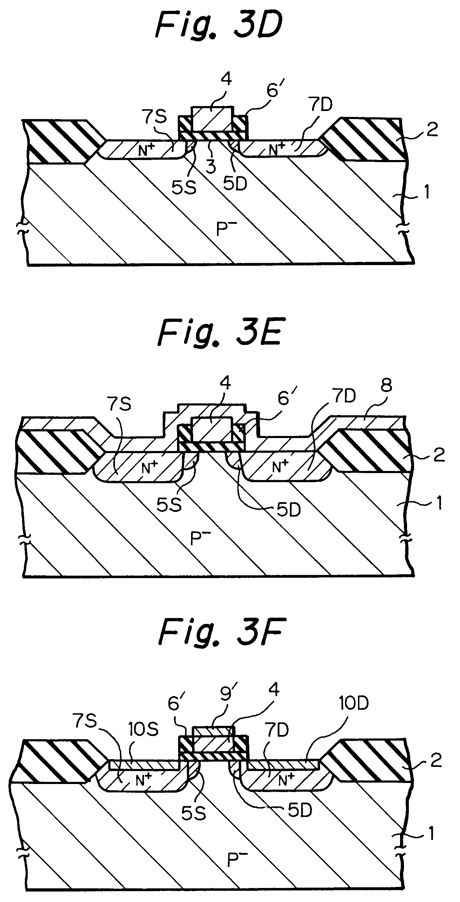

Next, as illustrated in Fig. 3D, a thickness of about 50 nm of the sidewall oxide layer 6 is etched by buffered fluoric acid, to leave it as a sidewall oxide layer 6'. In this case, the etching rate of an As-doped portion of the sidewall oxide layer 6 by the buffered fluoric acid is larger than that of a non-As-doped portion of the sidewall oxide layer 6 by the buffered fluoric acid. Thus, the height of the sidewall oxide layer 6' is lower than that of the polycrystalline silicon layer 4 by about 50 nm. Next, N-type impurities such as arsenic (As) are doped with a mask of the field oxide layer 2, the polycrystalline silicon layer 4 and the sidewall oxide layer 6' to form N⁺-type impurity diffusion egions (source and drain regions) 7S and 7D. Next, in Fig. 3E, in the same way as in Fig. 2C, a native oxide layer on the polycrystalline silicon layer 4 and the impurity diffusion regions 7S and 7D is etched out. Next, an about 100 nm thick titanium layer 8 is formed by a sputtering method.

Next, in Fig. 3F, in the same way as in Fig. 2D, the titanium layer 8 is reacted by a heat treatment under a nitrogen atomosphere on the polycrystalline silicon layer 4 and the N⁺-type impurity diffusion regions 7S and 7D, to thereby form a titanium silicide layer 9' on the polycrystalline silicon layer 4 and titanium silicide layers 10S and 10D on the diffusion regions 7S and 7D. After that, an unreacted potion of the titanium layer 8 on the field oxide layer 2 and the sidewall oxide layer 6 are removed by a wet etching method.

After that, in the same way as in the prior art, an insulating interlayer (not shown) is deposited, and contact holes (not shown) are formed in this insulating interlayer. Further, aluminum connection layers (not shown) are formed within the contact holes, thus completing a MOS transistor with an LDD construction.

Thus, also according to the second embodiment, since the sidewall oxide layer 6' is lower than the polycrystalline silicon layer 4, the thickness of the titanium silicide layer 9' on the polycrystalline silicon layer 4 can be uniform at the center and side portions thereof.

In the second embodiment, note that the etching of the sidewall oxide layer 6' can be carried out after the formation of the impurity diffusion regions.

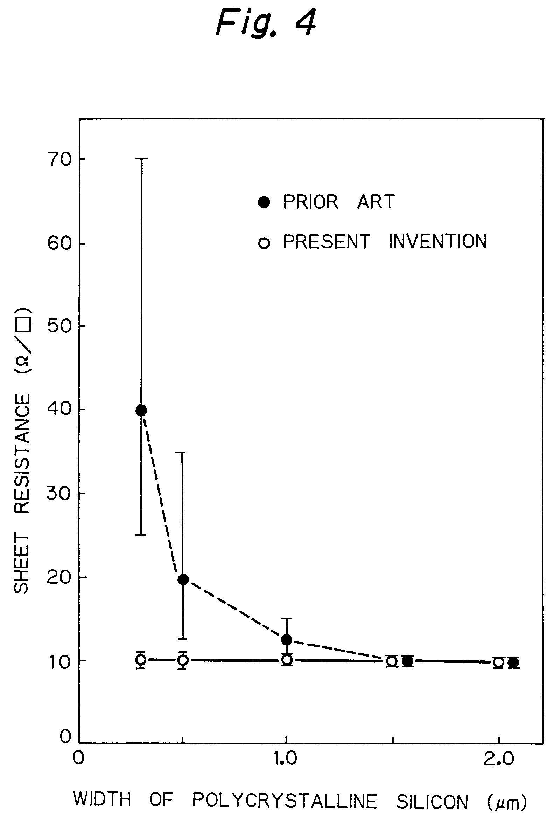

Thus, since the thickness of the titanium silicide layer 9' is uniform on the polycrystalline silicon layer 4, the sheet resistance of the titanium silicide layer 9' is hardly fluctuated and is not increased, as shown in Fig. 4. Note that, in the prior art, when the width of the polycrystalline silicon layer 4 is decreased, the sheet resistance of the titanium silicide layer 9 was remarkably fluctuated and increased. Contrary to this, in the present invention, since the titanium silicide layer 9' is thick and uniform on its sides, the titanium silicide layer 9' is hardly agglomerated by a post-stage heat process such as a reflowing process of the interlayer, and therefore, the sheet resistance is not increased. Thus, althouth it was possible in the prior art to carry out only a heat operation at a lower temperature than 750°C, it is possible in the present invention to carry out even a heat operation at 800°C, thus improving the thermal stability.

In the above-mentioned embodiments, note that although titanium is used as a high melting point (refractor) metal for a silicide, tungsten, cobalt or molybdenum can be used, and also, a laminated construction of titanium and cobalt can be used. Further, although the silicon oxide layer is used as the sidewall insulating layer, a silicon nitride layer or a silicon nitride/oxide layer can be used as such. Still further, the present invention can be applied to a P-channel MOS transistor and a CMOS device in addition to an N-channel MOS transistor.

As explained hereinbefore, according to the present invention, the fluctuation and increase of thickness of a metal silicide layer can be avoided, so that the reduction of the manufacturing yield is prevented, thus reducing the manufacuring cost of semiconductor devices.

## Claims

1. A method for manufacturing a semiconductor device comprising the steps of:

    forming a polycrystalline silicon layer (4) on a semiconductor substrate (1);

    forming a sidewall insulating layer (6') on a side surface of said polycrystalline silicon layer, said side wall insulating layer having a lower height than said polycrystalline silicon layer;

    forming a refractory metal layer (8) on said semiconductor substrate, said polycrystaline silicon layer and said sidewall insulating layer; and

    carrying out a heat operation upon said refractory metal layer and said polycrystalline silicon layer to react said refractory metal layer on said polycrystalline silicon layer, to thereby form a metal silicide layer (9').

2. A method as set forth in claim 1, wherein said sidewall insulating layer forming step comprises the steps of:

    forming an insulating layer in said semiconductor substrate and said polycrystalline silicon layer; and

    etching said insulating layer by an anisotropic etching method for a time period sufficiently longer than a time period by which said insulating layer is completely etched, to leave said insulating layer as said sidewall insulating layer on a side surface of said polycrystalline silicon layer.

3. A method as set forth in claim 2, wherein an etching rate of said insulating layer by an anisotropic etching method is lower than an etching rate of a thermally-grown silicon oxide layer by the anisotropic etching method.

4. A method as set forth in claim 3, wherein said insulating layer forming step forms a silicon oxide layer by a low temperature CVD as said insulating layer.

5. A method as set forth in claim 2, wherein said sidewall insulating layer is one of a silicon nitride layer, a silicon nitirde layer and a silicon nitride/oxide layer.

6. A method as set forth in claim 1, wherein said sidewall insulating layer forming step comprises the steps of:

    forming an insulating layer on said semiconductor substrate and said polycrystalline silicon layer;

    etching back said insulating layer by an anisotropic etching method to leave a sidewall insulating layer (6) having the same height as said polycrystalline silicon layer;

    introducing impurities into at least an upper portion of said sidewall insulating layer; and

    etching said sidewall insulating layer with impurities introduced therein by using an etching method having an etching rate suitable to remove the upper portion of said sidewall insulating layer.

7. A method as set forth in claim 6, wherein said sidewall insulating layer is constructed by a silicon oxide layer,

    said etching step etching by using fluoric acid.

8. A method as set forth in claim 1, wherein said refractory metal layer is made of one of titanium, cobalt, molybdenum and tungsten.

9. A method as set forth in claim 1, wherein said refractory metal layer is made of laminated films of titanium and cobalt.

10. A method for manufacturing a semiconductor device comprising the steps of:

    forming a polycrystalline silicon layer (4) on a semiconductor substrate (1);

    forming an insulating layer in said semiconductor substrate and said polycrystalline silicon layer;

    etching said insulating layer by an anisotropic etching method for a time period sufficiently longer than a time period by which said insulating layer is completely etched, to leave said insulating layer as a sidewall insulating layer (6') on a side surface of said polycrystalline silicon layer;

    forming a refractory metal layer (8) on said semiconductor substrate, said polycrystalline silicon layer and said sidewall insulating layer; and

    carrying out a heat operation upon said high melting point metal layer and said polycrystalline silicon layer to react said refractory metal layer on said polycrystalline silicon layer, to thereby form a metal silicide layer (9').

11. A method for manufacturing a semiconductor devoce comprising the steps of:

    forming a polycrystalline silicon layer (4) on a semiconductor substrate (1);

    forming an insulating layer on said semiconductor substrate and said polycrystalline silicon layer;

    etching back said insulating layer by an anisotropic etching method to leave a sidewall insulating layer (6) having the same height as said polycrystalline silicon layer;

introducing impurities into at least an upper portion of said sidewall insulating layer;

etching said sidewall insulating layer with impurities introduced therein by using an etching method to remove the upper portion of said sidewall insulating layer;

forming a refractory metal layer (8) on said semiconductor substrate, said polycrystalline silicon layer and said sidewall insulating layer; and

carrying out a heat operation upon said high melting point metal layer and said polycrystalline silicon layer to react said refractory metal layer on said polycrystalline silicon layer, to thereby form a metal silicide layer (9').

## Fig. 1A PRIOR ART

As⁺    As⁺         As⁺    As⁺

## Fig. 1B PRIOR ART

As⁺    As⁺         As⁺    As⁺

# *Fig. 1C* PRIOR ART

# *Fig. 1D* PRIOR ART

# Fig. 2A

# Fig. 2B

## Fig. 2C

## Fig. 2D

*Fig. 3A*

*Fig. 3B*

*Fig. 3C*

11

## Fig. 3D

## Fig. 3E

## Fig. 3F

# Fig. 4

Legend:
- ● PRIOR ART
- ○ PRESENT INVENTION

Y-axis: SHEET RESISTANCE ($\Omega/\square$)

X-axis: WIDTH OF POLYCRYSTALLINE SILICON ($\mu$m)